# EUROPÄISCHE PATENTSCHRIFT

(11) **EP 2 100 322 B1**
(45) Veröffentlichungstag und Bekanntmachung des Hinweises auf die Patenterteilung: **18.05.2016**
(21) Anmeldenummer: 07846965.7
(22) Anmeldetag: 03.12.2007
(51) Int. Cl.: H01J 37/32, H01J 37/34

(54) **VAKUUMBESCHICHTUNGSANLAGE ZUR HOMOGENEN PVD-BESCHICHTUNG**
VACUUM COATING UNIT FOR HOMOGENEOUS PVD COATING
INSTALLATION DE REVETEMENT SOUS VIDE POUR REVETEMENT PVD HOMOGENE

(30) Priorität: 07.12.2006 DE 102006058078
(43) Veröffentlichungstag der Anmeldung: 16.09.2009
(73) Patentinhaber: Systec System- und Anlagentechnik GmbH & Co. KG, 97753 Karlstadt (DE)
(72) Erfinder: MÜNZ, Wolf-Dieter, A-8160 Weiz/Steiermark (AT); KUNKEL, Stefan, 63599 Biebergemünd (DE)
(74) Vertreter: Plate, Jürgen
(86) Internationale Anmeldenummer: PCT/EP2007/010476
(87) Internationale Veröffentlichungsnummer: WO 2008/067969

(56) Entgegenhaltungen:
- WO-A-99/41425
- WO-A-2006/087558
- DE-A1- 10 018 143
- DE-A1- 10 314 932
- DE-A1- 19 860 474
- US-A1- 2001 009 225

## Beschreibung

Die Erfindung betrifft eine Vakuumbeschichtungsanlage zur homogenen PVD-Beschichtung von dreidimensionalen Substraten, umfassend eine Beschichtungskammer, zwei oder mehrere peripher innerhalb der Beschichtungskammer angeordnete Magnetronsputterquellen oder Arcverdampferquellen, einen Substratträger für die Halterung der Substrate, Vakuumpumpen und Spannungsquellen.

Die magnetfeldunterstützte Kathodenzerstäubung (Magnetron Sputtering) hat Eingang gefunden in viele Bereiche der modernen Oberflächentechnik. Ausgehend von Anwendungen in der Mikroelektronik ist die magnetfeldunterstützte Kathodenzerstäubung heute als industrielles Beschichtungsverfahren für Architekturglas, Flachbildschirme, Brillengläser, Bandmaterialien, Werkzeuge, dekorative Gegenstände und funktionelle Bauteile etabliert. Dabei werden funktionelle Bauteile oft mit Korrosionsschutz- oder Hartstoffschichten aus Nitriden wie TiN, TiAIN, VN, ZrN, CrN oder Karbonitriden wie TiCN in ein oder Mehrlagentechnik versehen. Zunehmend finden auch "superharte" Schichten auf Basis von Nano-Mehrlagenschichten mit Härtewerten bis zu 50 GPa Anwendung. In der Automobilindustrie sind reibungs- und verschleißmindernde Metall-Kohlenstoff-Schichten bestens bewährt.

Verfahren und Anlagen zur homogenen Beschichtung ebener Flächen, wie z.B. Silizium Wafer oder Glasscheiben sind technisch hoch entwickelt und gut beherrschbar. Allerdings weisen die auf dreidimensionalen Substratkörpern - wie z.B. Uhrengehäusen, Schreibgeräten, Brillengestellen, Schneid- und Umformwerkzeugen, medizinischen Geräten oder Komponenten des Automobil-, Maschinen- und Gerätebaus - abgeschiedenen Schichten mikroskopische Inhomogenitäten auf. Diese Inhomogenitäten beeinträchtigen die Schichtqualität und somit die funktionellen Eigenschaften und die mechanische Widerstandsfähigkeit der beschichteten Komponenten.

Die Inhomogenitäten sind eine Folge der Anisotropie des im Beschichtungsprozess eingesetzten Plasmas. Wird ein dreidimensionales Substrat vor einer planaren Kathode angeordnet, so ist der Abstand zwischen der Kathode und den Punkten auf der Substratoberfläche nicht konstant. Darüber hinaus schattet die der Kathode zugewandte vordere Hälfte des Substrats die rückwärtige Seite vom Plasma der Kathoden und damit von dem Ionenbeschuss und auch vom Materialfluss ab. Auf der rückwärtigen, von der Kathode abgewandten Substratseite ist die Intensität des Ionenbeschusses wesentlich geringer als auf der vorderen, dem Plasma der Kathoden ausgesetzten Substratseite. Für viele Anwendungen ist jedoch eine gleichmäßige Beschichtung der Substrate erforderlich. Eine bewährte Methode zur gleichmäßigen Beschichtung dreidimensionaler Substrate besteht darin, die Substrate vor der Beschichtungsquelle zu rotieren, wobei ein bestimmter Punkt der Substratoberfläche periodisch Bereiche mit intensivem und mit schwachem Ionenbeschuss durchläuft. Hierdurch wird eine mehrlagige Beschichtung abgeschieden, die abhängig von der Rotationsgeschwindigkeit und Abscheiderate aus Lagen mit Dicken im Bereich von wenigen Nanometern bis zu einigen Mikrometern besteht. Ein derartig inhomogener Schichtaufbau beeinflusst die Mikrostruktur, Härte, Eigenspannung, Verschleiß- und Korrosionsfestigkeit sowie die Farbe der Beschichtung zumeist in unerwünschter Weise.

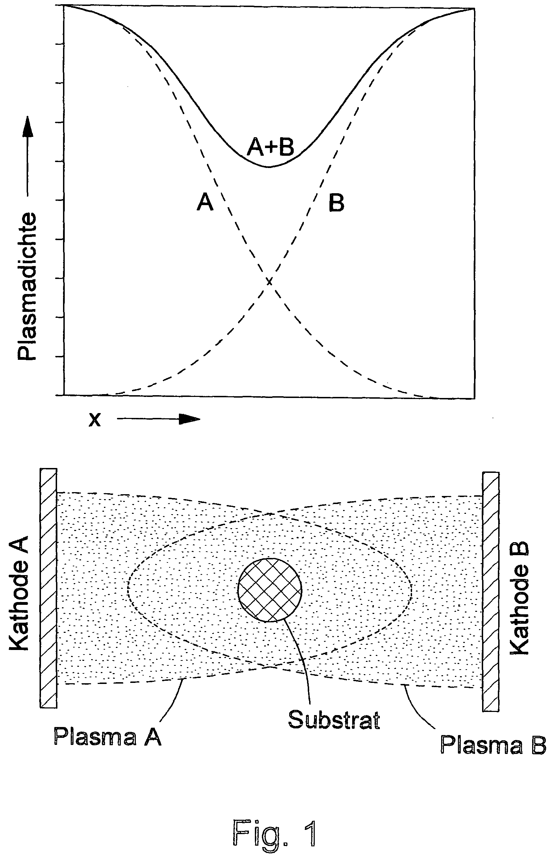

Wie oben erörtert, liegt die Hauptursache für den inhomogenen Schichtaufbau in der Begrenzung des bei der Magnetronentladung erzeugten Plasmas auf eine Raumzone vor der Kathode. Die Intensität des Ionenbeschusses der aufwachsenden Schicht variiert mit dem Abstand der Substratoberfläche von der Kathode. Diese räumliche Variation kann bei Substraten mit geringer Tiefenabmessung nahezu vollständig kompensiert werden, indem die Substrate während der Beschichtung zwischen zwei sich gegenüberstehenden Kathoden positioniert werden (siehe Fig. 1). Die von den beiden Kathoden ausgehenden Plasmen überlagern sich in der Mitte, wobei eine Raumzone mit praktisch isotropem Plasma und gleichmäßigen Beschichtungsbedingungen gebildet wird. Es ist bekannt, dass auf diese Weise z.B. zylindrische Substratkörper bis zu einem Durchmesser von 10 mm gleichmäßig rundum beschichtet werden können, ohne dass eine spezielle Substratrotation um die Zylinderachse erforderlich ist.

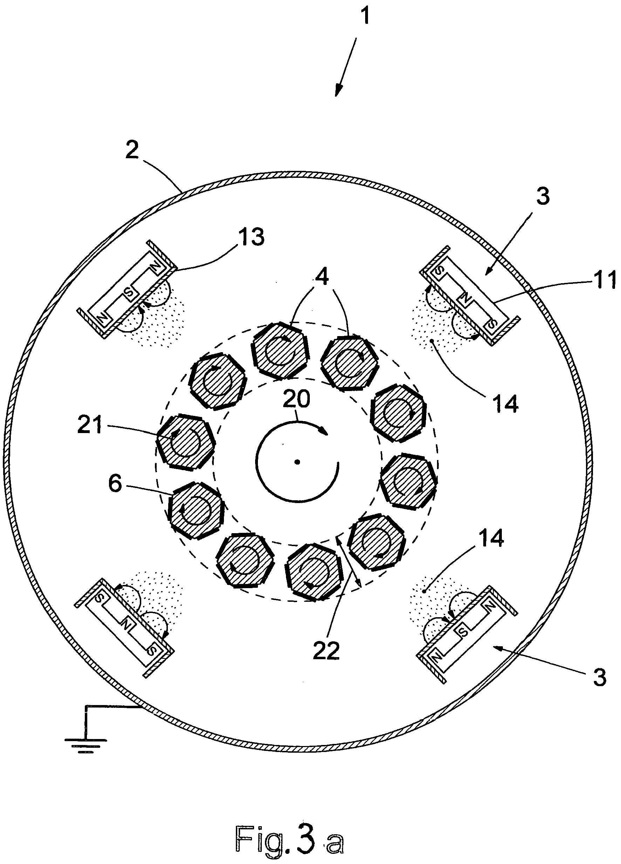

Sogenannte "balancierte" planare Magnetronkathoden (siehe Fig. 3a) sind mit Permanentmagneten ausgestattet, die vor dem auf der Kathode montierten Target ein tunnelförmiges geschlossenes Magnetfeld erzeugen. Wird dieser geschlossene Magnettunnel mit einem elektrischen Feld überlagert, so erfolgt die Bewegung der Elektronen vor dem Target auf schraubenförmigen Bahnen. Dies bedeutet, dass die Elektronen in einem Raumvolumenelement längere Wege zurücklegen als im Falle einer Kathode ohne Magnetfeld, bei der sich die Elektronen entlang der elektrischen Feldlinien - zumeist linear-bewegen. Hierdurch nimmt die Anzahl der Stöße zwischen Elektronen und Gasatomen bzw.-molekülen je Raumvolumenelement zu und damit verbunden erhöht sich die Gasionisation, wobei sich ein intensives Plasma ausbildet, das vor dem Target im Bereich des Magnettunnels eingeschlossen wird.

Wichtige Eigenschaften der abgeschiedenen Schichten, wie z.B. Zusammensetzung, Morphologie, Haftung und Eigenspannung werden durch das Schichtwachstum auf dem Substrat maßgeblich bestimmt. Es ist bekannt, dass das Schichtwachstum und damit die Schichteigenschaften durch Ionenbeschuss während des Beschichtungsvorgangs beinflusst werden. So haben Thornton (J. A. Thornton, Annu. Rev. Mater. Sci. 7, p. 239, 1977) und Messier (R. Messier, J. Vac. Sci. & Technol., 2, 500, 1984) in ihren Arbeiten die Abhängigkeit der Schichtstruktur von Gasdruck und Ionenbeschuss während des Schichtwachstums untersucht. Insbesondere bei Hartstoffschichten, die aus Materialien mit hohem Schmelzpunkt bestehen und deren Schichtwachstum in dem von Thornton und Messier entwickelten Strukturzonenmodell durch die Zone T beschrieben wird, ist ein intensiver Ionenbeschuss zwingend erforderlich, um kompakte bzw. dichte Schichten abzuscheiden. Um einen intensiven Ionenbeschuss der Substrate zu realisieren, werden im Stand der Technik sogenannte "unbalancierte" Magnetronkathoden eingesetzt. Bei einem unbalancierten Magnetron ist ein Teil der magnetischen Feldlinien nicht vor dem Kathodentarget geschlossen, sondern verläuft in Richtung des Beschichtungsraums, in welchem sich die Substrate befinden. Aufgrund dieser Feldkomponenten wird ein Teil der Elektronen in Richtung der Substrate geführt, so dass sich das Plasma zu den Substraten hin ausdehnt. Durch das Anlegen eines Substratpotentials werden Ionen aus dem substratnahen Plasma auf die aufwachsende Schicht beschleunigt und der für das Schichtwachstum vorteilhafte Ionenbeschuss liegt vor.

Beispiele für Verfahren und Vorrichtungen zur Kathodenzerstäubung mit Ionenunterstützung sind im nachfolgenden Stand der Technik aufgeführt.

DE 40 42 289 A1 betrifft eine Vorrichtung zum reaktiven Beschichten eines Substrates, die eine Magnetron-Kathode und eine separate von der Beschichtungskammer elektrisch isolierte Anode beinhaltet. Die Anode ist ringartig gestaltet und räumlich zwischen der Magnetron-Kathode und dem zu beschichtenden Substrat angeordnet. Die direkte Sichtverbindung zwischen Magnetron-Kathode und Anode ist durch eine Blende unterbunden, wodurch die Beschichtung der Anode vermieden wird. Bei reaktiven Beschichtungsprozessen mit Materialien, die eine hohe Affinität zum Reaktivgas haben, können die Innenwände der Beschichtungskammer, Blenden und andere Einbauten mit elektrisch nichtleitenden oder schlecht leitenden Belägen beschichtet werden. Der Einsatz einer gegen Beschichtung abgeschirmten Anode ermöglicht es in einem solchen Fall, den Beschichtungsprozess stabil und Arcing-frei zu führen, wobei es nicht erforderlich ist, die Beschichtungskammer und deren Einbauten häufig zu reinigen bzw. die Einbauten häufig auszutauschen.

Aus der WO2006/099760 A2 ist eine Vakuumprozessanlage zur Oberflächenbearbeitung von Werkstücken mit einer Arcverdampfungsquelle bekannt, die eine erste Elektrode enthält, die mit einer DC-Stromversorgung verbunden ist. Die Anlage enthält eine zweite, von der Arcverdampferquelle getrennte Elektrode. Die beiden Elektroden sind jeweils mit einer Pulstromversorgung verbunden.

Eine Lichtbogen-Beschichtungsanlage gemäß EP 0 534 066 A1 umfasst eine die zu beschichtenden Teile enthaltende Kammer, die mit Kathoden/Verdampfern und einer ersten und einer zweite Anode ausgestattet ist. Während des Beschichtungsvorgangs wird die zweite Anode auf einem Potential gehalten, das höher ist als das Potential der ersten Anode. Die Substrate befinden sich hierbei auf einem negativen Potential, das größer ist als das negative Potential der Kathode. In der beschriebenen Anordnung wird durch die Anoden ein Teil der Elektronen aus dem Kathodenplasma abgesaugt und in die Beschichtungskammer hienein beschleunigt. Hierdurch wird die Ionisation der in der Beschichtungskammer befindlichen Gase verstärkt und der Ionenbeschuss der Substrate intensiviert.

Die in US 5 556 519 A beschriebene Vorrichtung zur Beschichtung von Substraten mittels magnetfeldunterstützter Niederdruck-Entladungen umfasst zwei oder mehrere Magnetronkathoden. Die äußeren magnetischen Pole benachbarter Magnetronkathoden weisen entgegengesetzte Polarität auf und erzeugen einen Magnetfeldkäfig, der praktisch alle Elektronen der Niederdruck-Entladungen einschließt. Hierdurch wird im Raum vor den Kathoden der Ionisierungsgrad der Niederdruck-Entladungen erhöht und der Ionenbeschuss der Substrate intensiviert.

DE 31 07 914 A1 lehrt ein Verfahren und eine Vorrichtung zur Beschichtung eines Formteils mit dreidimensionaler Beschichtungsfläche durch magnetfeldunterstützte Kathodenzerstäubung, bei dem das Formteil zwischen zwei sich gegenüberstehenden Kathoden angeordnet ist und zugleich den Plasmawolken beider Kathoden ausgesetzt ist. An das Formteil wird eine gegenüber Massepotential negative Spannung niedriger/gleich -10 V angelegt. Die Plasmen der gegenüberliegend angeordneten Kathoden werden so überlagert, dass das Formteil einem rundum gleichmäßigen Ionenbeschuss ausgesetzt ist.

DE 38 37 487 A1 offenbart ein Verfahren und eine Vorrichtung zum Ätzen von Substraten mittels einer magnetfeldunterstützten Niederdruck-Entladung. Die Substrate sind zwischen Elelctronen-Emittern und Anoden angeordnet. Die Elektronen-Emitter sind von dem Magnetfeld eines auf Massepotential befindlichen Magnetsystems umgeben. An die Substrate werden negative Potentiale von 100 bis 1000 V angelegt. Die Anodenpotentiale betragen 10 bis 250 V. Aus den mit Strom beheizten Elektronen-Emittern treten Elektronen und werden zu den Anoden hin beschleunigt. Die Elektronen kollidieren mit Gasatomen bzw. -molekülen, wobei durch Stoßionisation Gasionen und weitere Elektronen generiert werden. Das so erzeugte Plasma dehnt sich aus und durchdringt die Substratanordnung. Aufgrund des negativen Substratpotentials werden die positiven Gasionen aus dem Plasma beschleunigt, so dass eine intensive Ionenätzung der Substrate erzielt wird.

WO 1998 0 31041 A1 beschreibt eine Vorrichtung und ein Verfahren zur Einstellung der Ionenstromdichte am Substrat. Die Vorrichtung besteht aus einer an ihrem Außenumfang mit Magnetronkathoden oder Ionisationsquellen bestückten Vakuumkammer, die um eine Beschichtungszone herum angeordnet sind und in deren Zentrum sich eine aus einzelnen Permanentmagneten zusammengesetzte Magnetanordnung befindet. Die Polungen der Magnetanordnung und der sie umgebenden Magnetronkathoden/Ionisationsquellen können gleich oder entgegen gerichtet sein. Zusätzlich kann die magnetische Feldstärke der Magnetanordnung und die Position bzw. Orientierung ihrer Einzelmagnete variiert werden. Hieraus resultieren vielfältige Möglichkeiten zur Einstellung des magnetischen Feldes in der Beschichtungszone und damit verbunden zur Steuerung der Ionisation am Substrat. Z.B. werden bei umgekehrter Polung der Magnetanordnung und der Magnetronkathoden magnetische Feldlinien durch die Beschichtungszone geführt, was eine erhöhte Ionisation am Substrat zur Folge hat. Die in der Beschichtungszone positionierten Substrate können mit oder ohne Anlegen eines elektrischen Potentials beschichtet werden. Zur elektrischen Versorgung der Substrate können sowohl DC-, AC-, gepulste DC-, MF- und RF-Quellen eingesetzt werden.

DE 103 14 932 A1 offenbart eine Vakuumbeschichtungsanlage gemäß dem Oberbegriff des Anspruchs 1.

Bei der industriellen Beschichtung von dreidimensionalen Substraten arbeitet die überwiegende Zahl der im Stand der Technik bekannten PVD-Verfahren mit stark inhomogenen Entladungsplasmen. Die mit diesen PVD-Verfahren auf dreidimensionalen Substraten abgeschiedenen Schichten weisen daher Inhomogenitäten auf. Demgegenüber umfassen einige der bekannten PVD-Verfahren und -Anlagen Maßnahmen bzw. Vorrichtungen, die ein homogenes Entladungsplasma aufweisen, jedoch mit erheblichem apparativen Aufwand und Kosten, geringem Substrat-Durchsatz und/oder einer Begrenzung der Substratdicke verbunden sind.

Dementsprechend hat die vorliegende Erfindung die Aufgabe, eine Vorrichtung zu schaffen, die es ermöglicht, dreidimensionale Substrate auf kostengünstige und effektive Weise mit einer homogenen PVD-Beschichtung auszurüsten, die Ionisierung des verdampften Materials zu erhöhen ebenso die Elektronenemission und die Ionisierung des Reaktivgases.

Diese Aufgabe wird durch eine Vakuumbeschichtungsanlage der eingangs beschriebenen Art in der Weise gelöst, dass nur eine einzelne, zentrale Anode mit einer Pulsspannungsquelle und die jeweiligen Magnetronsputterquellen oder Arcverdampferquellen mit Pulsspannungsquellen verbunden sind.
In Weiterbildung der Erfindung sind die Magnetronsputterquellen oder Arcverdampferquellen mit DC-Spannungsquellen verbunden.

Die weitere Ausgestaltung der Erfindung ergibt sich aus den Merkmalen der Ansprüche 3 bis 10.

Um einen hohen Substratdurchsatz bei zugleich kompakter Bauweise zu realisieren, wird die erfindungsgemäße Vorrichtung bevorzugt mit vier oder sechs Kathoden ausgestattet. Insbesondere sind die Kathoden als balancierte Magnetronkathoden ausgeführt, die mittels konzentrisch um die Magnetronkathoden angeordneter elektromagnetischer Spulen als unbalancierte Magnetrons betrieben werden. Als Kathoden können planare Rechteckkathoden (Linearkathoden) oder planare Rundkathoden eingesetzt werden.

Vorzugsweise zeichnet sich die Anode dadurch aus, dass sie:
von teleskopartiger Konstruktion ist, so dass die Anodenlänge zwecks Be- und Entladen der Beschichtungskammer reduziert werden kann;
mit einer Kühlvorrichtung ausgestattet ist zur Kompensation der Anodenaufheizung durch Plasmen mit hoher Leistungsdichte; und
aus rostfreiem Stahl, Graphit oder metallummanteltem Graphit besteht.

Zwecks horizontaler Be- und Entladung von Substraten ist die Beschichtungskammer mit einer seitlich angeordneten Valcuumtür oder Vakuumschleuse ausgestattet.

In einer bevorzugten Ausführungsform der Erfindung ist die Beschichtungskammer mit einem Rezipienten zur Aufnahme der zentralen Anode verbunden. Um die Anode beim Belüften der Beschichtungskammer vor Kontamination zu schützen, ist zwischen dem Rezipienten und der Beschichtungskammer ein Ventil installiert.

Zwischen der einzelnen, zentral positionierten Anode und mehreren Kathoden wird mittels Gasentladungen Plasma erzeugt, wobei die Substrate während der Beschichtung von Plasma umgeben sind.

Erfindungsgemäß werden die Gasentladungen in einem Modus betrieben, bei dem der Ionenbeschuss der den Kathoden sowie den Anoden zugewandten Substratzonen eine mittlere Stromdichte von 0,2 bis 8,0 mA/cm², bevorzugt von 0,2 bis 5,0 mA/cm² und insbesondere von 1,0 bis 3,0 mA/cm² aufweist.

Während des Beschichtungsvorgangs werden die Substrate typischerweise bewegt. Insbesondere werden die Substrate auf einer um die Anode zentrierten Kreisbahn zwischen der Anode und den Kathoden geführt und rotieren simultan um vertikale, auf der zentrierten Kreisbahn mitgeführte Achsen.

Durch wechselnde magnetische Polung benachbarter Kathoden wird ein geschlossenes Magnetfeld erzeugt, wobei das Magnetfeld das Plasma im Inneren der Beschichtungskammer und beabstandet von der Wand der Beschichtungskammer einschließt.

Im Weiteren wird die Erfindung anhand von Zeichnungen und Beispielen näher erläutert. Es zeigen:
- Fig. 1: Die Plasmaverteilung einer Doppelkathode;
- Fig. 2: eine erfindungsgemäße Vorrichtung mit zentraler Anode;
- Fig. 3a: die Plasmaverteilung in einer bekannten PVD-Beschichtungsanlage mit balancierten Magnetronkathoden;
- Fig. 3b: die Plasmaverteilung in einer bekannten PVD-Beschichtungsanlage mit unbalancierten Magnetronkathoden;
- Fig. 3c: die Plasmaverteilung in einer erfindungsgemäßen Vorrichtung mit zentraler Anode;
- Fig. 4a: eine Beschichtungskammer mit Rezipient für die zentrale Anode;
- Fig. 4b: eine zentrale Anode von teleskopartiger Konstruktion.

Fig. 1 illustriert die Funktionsweise der im Stand der Technik bekannten Doppelkathoden-Anordnung. Ein Substrat ist mittig zwischen zwei sich gegenüberstehenden Kathoden A und B positioniert. Die Dichte des von jeder einzelnen Kathode erzeugten Plasmas nimmt mit dem ) Abstand von der Kathode rasch ab, so dass jedes einzelne Plasma A bzw. B auf das Substrat stark unterschiedlich (anisotrop) einwirkt. Demgegenüber entsteht durch die Überlagerung der beiden Plasmen A und B am Ort des Substrates eine Raumzone mit einer im wesentlichen gleichmäßigen (isotropen) Plasmadichte.

In der industriellen Beschichtungstechnik werden vorzugsweise Magnetronkathoden eingesetzt. Hinter dem Target, das beim Beschichtungsprozess abgetragen (zerstäubt) wird, sind Permanentmagnet-Segmente angeordnet, wobei ein inneres lineares Magnetsegment von einem äußeren Ring aus Magnetsegmenten mit umgekehrter Polung umgeben ist. Diese Magnetanordnung erzeugt vor dem Target ein tunnelförmiges geschlossenes Magnetfeld, das beim Beschichtungsvorgang den Einschluss des Entladungsplasmas bewirkt. Eine wassergekühlte Trägerplatte führt die bei hohen Kathodenleistungen an der Targetoberfläche erzeugte Wärmeenergie ab.

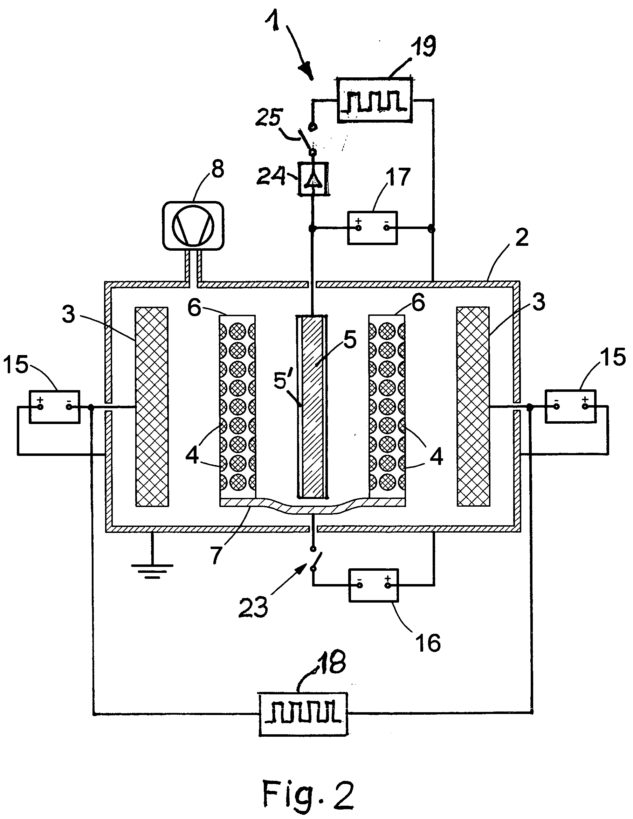

Fig. 2 zeigt schematisch eine beispielhafte Ausführung der erfindungsgemäßen Vorrichtung 1. Im Zentrum einer vakuumdichten Beschichtungskammer 2 ist eine Anode 5 angeordnet. Die Anode 5 ist umgeben von zwei oder mehr Kathoden 3, die an der Innenwand der Beschichtungskammer 2 angebracht sind. Die Anzahl der Kathoden 3 beträgt n mit n = 2, 4, 6, 8 oder 2n+1 mit n = 1, 2, 3. Zwischen der Anode 5 und den Kathoden 3 befinden sich mit Substraten 4 bestückte Substratträger 6. Die Substratträger 6 sind auf einem zur Anode 5 axial zentrierten Drehteller 7 montiert. Der Drehteller 7 und die auf Planetenachsen gelagerten Substratträger 6 werden mittels Motoren angetrieben, so dass die Substratträger 6 auf einer Kreisbahn zwischen der Anode 5 und den Kathoden 3 hindurchgeführt werden und simultan hierzu um ihre Längsachse rotieren.

Die Rotationsgeschwindigkeiten der Substratträger 6 (ω_{S}) und des Drehtellers 7 (ω_{D}) sind so abgestimmt, dass die mittlere Verweildauer jedes Substrats 4 vor den Kathoden 3 gleichlang ist. Dies wird z.B. erreicht, wenn ω_{S} ein Vielfaches von ω_{D} beträgt: ω_{S} = m·ω_{D} mit m > 3. Hierdurch wird eine gleichmäßige Beschichtung der Substrate gewährleistet.

Die Beschichtungskammer 2 ist mit mindestens einem inerten oder reaktiven Prozessgas wie z.B. Argon, Neon, Helium oder Sauerstoff, Stickstoff, Acetylen gefüllt, dessen Druck mittels ) mit der Beschichtungskammer 2 verbundener Vakuumpumpen 8 im Bereich von 10⁻³ bis 0,1 mbar gehalten wird. Die Substrate 4, die Kathoden 3 und die Anode 5 sind mit DC-Spannungsquellen 15, 16, 17 verbunden, wobei das Bezugspotential der Spannungsquellen 15, 16, 17 und das Potential der Beschichtungskammer 2 auf Massepotential liegt. Üblicherweise werden an die Anode 5 Potentiale von +20 bis +200 V, an die Kathoden 3 Potentiale von -50 bis -1000 V und an die Substrate 4 Potentiale von 0 bis -1000 V angelegt. Alternativ können die Substrate 4 isoliert bzw. auf floatendem Potential gehalten werden-wie in Fig. 2 durch einen geöffneten Schalter 23 angedeutet. Die Anode 5 wird durch eine nicht gezeigte Kühlvorrichtung gekühlt.
Die Anode 5 ist zusätzlich mit einer Pulsspannungsquelle 19 verbunden, die parallel zu der DC-Spannungsversorgung geschaltet ist. Die Pulsspannungsquelle 19 liefert eine unsymmetrische Pulsfolge von positiven und negativen Pulsen an die Anode 5. Ebenso kann es sich um eine unipolare oder bipolare Pulsspannungsversorgung handeln. In der elektrischen Zuleitung der Pulsspannungsquelle 19 zur Anode 5 ist eine über einen Schalter 25 betätigbare Einrichtung 24 positioniert, die im eingeschalteten Zustand nur positive Pulse zu der Anode 5 passieren lässt. Bei der Einrichtung 24 handelt es sich beispielsweise um zumindest eine Sperrdiode oder eine Anordnung mehrerer Sperrdioden für negative Pulse.
In der Zeichnung sind die Kathoden 3 als balancierte oder unbalancierte Magnetronsputterquellen dargestellt. Anstelle von Magnetronsputterquellen können auch nicht gezeigte Arcverdampferquellen zum Einsatz gelangen. Die Magnetronsputterquellen bzw. Kathoden 3 sind mit Pulsspannungsquellen 18, 18 ..... verbunden, von denen eine in Fig. 2 dargestellt ist. Die Pulsspannungsquellen 18, 18 ..... können sinusfömige Wechselspannungen, uni- oder bipolare Pulsspannungen liefern.
Die Pulsspannungsquellen 18, 19 erzeugen Spannungen in der Größenordnung von -500 V bis +500 V und die Frequenz der Pulse liegt im Bereich von 5 bis 300 kHz.
Das Material der Anode 5 ist beispielsweise aus der Gruppe Al, AlCr, ZrN, CrN, TiAlN ausgewählt, wobei die Aufzählung keineswegs vollständig ist, da weitere Nitride, insbesondere Carbidnitride als Anodenmaterial geeignet sind. Das Material der Anode 5 ist das gleiche Material, das in den Targets der Kathoden 3 enthalten ist.

Durch die gepulste Anode 5 und die gepulsten Kathoden 3 erhöht sich die Elektronenemission, wodurch sich der Kathodenstrom und der Substratstrom erhöhen. Des Weiteren verstärkt sich die Ionisierung des verdampften Targetmaterials und des Reaktivgases. Die Substratoberflächen, d. h. die sich bildenden isolierenden Schichten, werden infolge erhöhter Elektronendichte schneller entladen.

Im Substratbereich verdichtet sich das Plasma und es erhöht sich die Reaktivität und es werden erhöhte Substrattemperaturen erzielt.

Der in Fig. 3a in Aufsicht dargestellte Querschnitt zeigt schematisch die räumliche Verteilung von Entladungsplasmen 14 in einer konventionellen PVD-Beschichtungsanlage mit vier als balancierte Magnetrons ausgeführten Kathoden 3, die jeweils ein Target 13 und einen hinter dem Target 13 angeordneten Permanentmagnetsatz 11 aufweisen. Wie die Pfeile 20 und 21 andeuten, werden die Substratträger 6 auf einer Kreisbahn an den Kathoden 3 vorbeigeführt und rotieren simultan um ihre Längsachse. Die Wand der Beschichtungskammer 2 fungiert hierbei als Anode; alternativ werden auch separate, unmittelbar neben den Kathoden 3 angeordnete Anoden eingesetzt (in Fig. 3a nicht gezeigt). An jeder Kathode 3 wird ein Entladungsplasma 14 gezündet, das sich in eine Raumzone vor der Kathode 3 erstreckt. Vor dem Target 13 überlagern sich das Magnetfeld des Permanentmagnetsatzes 11 und das-hierzu im wesentlichen senkrecht gerichtete - elektrische Feld des Kathodenpotentials, wodurch das Entladungsplasma 14 vor dem Target 13 konzentriert und nahezu vollständig eingeschlossen wird.

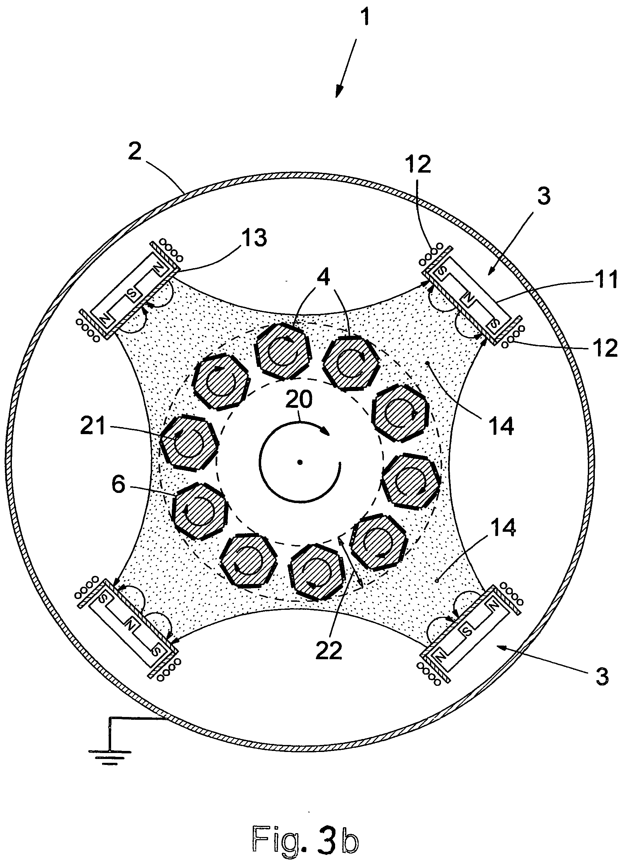

Fig. 3b zeigt eine weitere PVD-Beschichtungsanlage bekannten Typs mit vier als balancierte Magnetrons ausgeführten Kathoden 3, die jeweils mit einer elektromagnetischen Spule 12 ausgestattet sind. Mittels der elektromagnetischen Spule 12 wird ein zusätzliches Magnetfeld erzeugt dessen Feldlinien senkrecht zum Target 13 verlaufen und das Magnetfeld der Außenpole des Permanentmagnetsatzes 11 verstärken. Hierdurch wird der zuvor beschriebene Plasmaeinschluss vor den Kathoden 3 aufgehoben und das Entladungsplasma 14 füllt die Raumzone vor den Kathoden 3. Eine nach diesem Prinzip arbeitende Kathode wird allgemein als unbalancierte Magnetronkathode (Unbalanced Magnetron) bezeichnet. Die Stärke des von den elektromagnetischen Spulen 12 erzeugten Magnetfeldes bestimmt die Einspeisung und Aufweitung des Entladungsplasmas 14 in den Raum vor der Kathode 3. Somit können die Dichte und räumliche Ausdehnung des Entladungsplasmas 14 in einem begrenzten Bereich über die Stromstärke I_{UB} in den elektromagnetischen Spulen 12 gesteuert werden.

Wie jedoch in Fig.3b schematisch angedeutet, gelingt es auch mit unbalancierten Magnetronkathoden 3 nicht, die Entladungsplasmen 14 derart auszudehnen, dass die offenen Bereiche der Raumzone 22 durchdrungen werden und die Substrate 4 gleichmäßig von Plasma umgeben sind. Insbesondere, wenn der lichte Abstand zwischen benachbarten Substratträgern 6 klein ist, sind die von den Kathoden 3 abgewandten Substratseiten praktisch gänzlich von den Entladungsplasmen 14 abgeschirmt.

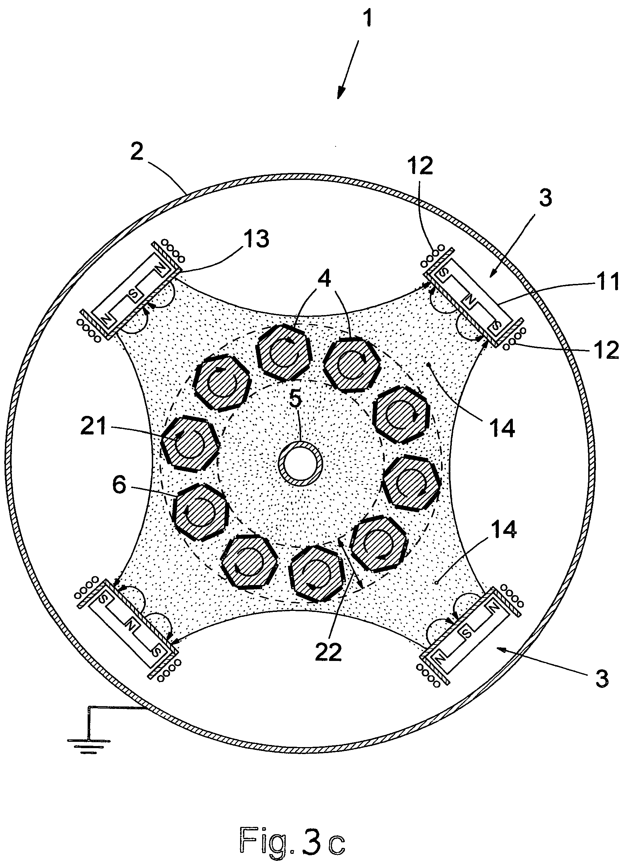

Fig. 3c zeigt eine PVD-Beschichtungsanlage, die erfindungsgemäß mit einer zentralen Anode 5 ausgerüstet ist. Die zentrale Anode 5 bewirkt, dass sich die Entladungsplasmen 14 bis in den zentralen Bereich der Beschichtungskammer 2 erstrecken. Die Entladungsplasmen 14 durchsetzen die offenen Bereiche der Raumzone 22 und füllen den Raum zwischen der Anode 5 und den Substratträgern 6, wobei die Substrate 4 von Entladungsplasmen 14 umschlossen werden. In Fig. 3c sind aus Vereinfachsgründen die Spannungsquellen nicht eingezeichnet.

Eine bevorzugte Ausgestaltung der Erfindung ist gekennzeichnet durch eine Anordnung, bei der die Permanentmagnetsätze 11 und die elektromagnetischen Spulen 12 benachbarter Kathoden 3 zueinander entgegengesetzte Polaritäten aufweisen und ein geschlossenes Magnetfeld erzeugen. Die räumliche Ausdehnung dieses geschlossenen Magnetfelds ist in Fig. 3c mittels nach innen gekrümmerter Linien illustriert, die jeweils von dem äußeren Nordpol eines Permanentmagnetsatzes 11 zu den äußeren Südpolen der beiden links und rechts benachbarten Permanentmagnetsätze 11 verlaufen.

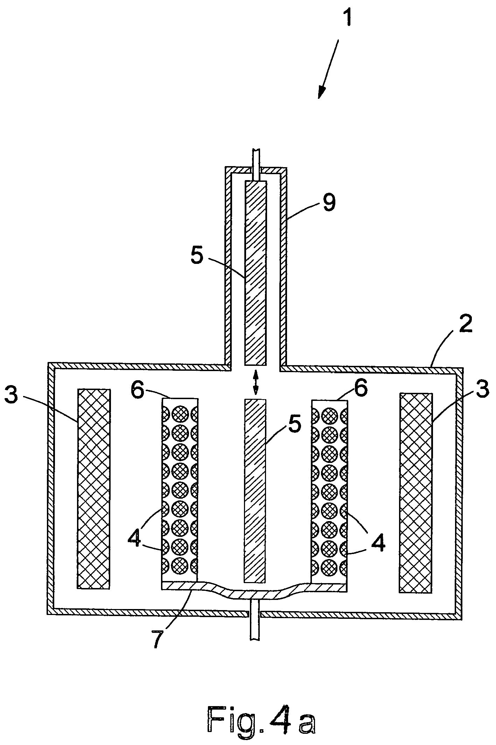

Industriell genutzte Beschichtungsanlagen weisen z.T. Höhen von mehr als zwei Metern auf. Zwecks effektiver Be- und Entladung der Substratchargen ist die Beschichtungskammer mit einer seitlich angeordneten Vakuumtür oder Vakuumschleuse ausgestattet. Eine derartige Valcuumtür/schleuse ermöglicht den horizontalen Zugang zum Inneren der Beschichtungsanlage. Fig. 4a zeigt schematisch eine derartige Ausführungsform der Erfindung, bei der die Beschichtungskammer 2 mit einem vertikalen Rezipienten 9 zur Aufnahme der Anode 5 ausgestattet ist. Die mit Substraten 4 bestückten Substratträger 6 sind auf einer Halteplatte oder direkt auf dem Drehteller 7 montiert. Zum Entladen der Beschichtungskammer 2 wird zunächst die Anode 5 mittels eines Stellmotors (nicht gezeigt) aus ihrer Arbeitsposition in ihre Be-/Entladeposition im Rezipienten 9 verfahren, um den Innenraum der Beschichtungskammer 2 freizugeben. Danach wird die Vakuumtür/-schleuse (nicht gezeigt) geöffnet und die Halteplatte mit den Substratträgern 6 und den Substraten 4 mittels eines Chargierwagens horizontal aus der Beschichtungskammer 2 entnommen. Zum Beladen der Beschichtungskammer 2 wird die Halteplatte bzw. der Drehteller 7 mit den Substratträgern 6 und den zu beschichtenden Substraten 4 mittels des Chargierwagens horizontal in die Beschichtungskammer 2 eingebracht. Bei Verwendung einer Halteplatte wird diese auf den Drehteller 7 gesetzt. Hieran anschließend wird die Vakuumtür/-schleuse geschlossen, die Beschichtungskammer 2 evakuiiert, die Anode 5 in ihre Arbeitsposition gefahren und der Beschichtungsprozess gestartet.

Um die Anode 5 beim Belüften der Beschichtungskammer 2 vor Kontamination zu schützen, ist es zweckmäßig, den Rezipienten 9 mit einem Ventil (nicht gezeigt) auszurüsten.

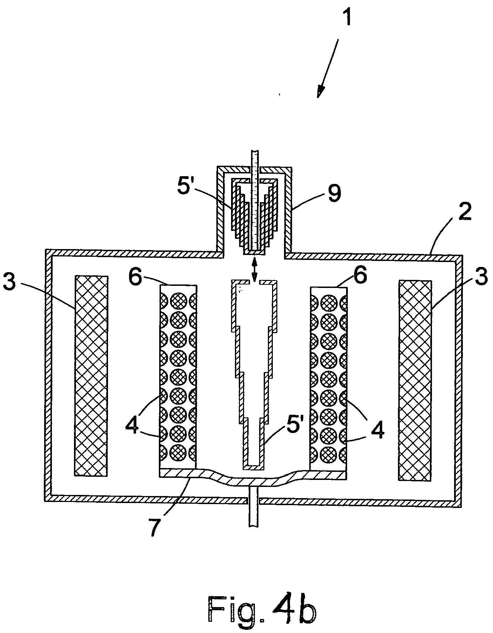

Fig. 4b, deren Bezugszahlen analog zu jenen der Fig. 4a sind, zeigt eine weitere Ausgestaltung der Erfindung, bei der eine Anode 5' eine teleskopartige Konstruktion aufweist. Vor dem Be-/Entladen der Beschichtungskammer 2 wird die Anode 5' teleskopartig eingezogen. Dadurch wird es möglich, die Bauhöhe des Rezipienten 9 im Vergleich zu der Ausführungsform nach Fig. 4a zu verringern bzw. gänzlich auf den Rezipienten 9 zu verzichten.

## Patentansprüche

1. Vakuumbeschichtungsanlage zur homogenen PVD-Beschichtung von dreidimensionalen Substraten (4), umfassend eine Beschichtungskammer (2), zwei oder mehrere peripher innerhalb der Beschichtungskammer (2) angeordnete Magnetronsputterquellen (3) oder Arcverdampferquellen, einen oder mehrere Substratträger (6) für die Halterung der Substrate (4), Vakuumpumpen (8) und Spannungsquellen (15, 16, 17, 18, 19) **dadurch gekennzeichnet, dass** nur eine einzelne zentrale Anode (5) mit einer Pulsspannungsquelle (19) und die jeweiligen Magnetronsputterquellen oder Arcverdampferquellen mit Pulsspannungsquellen(18, 18, ...) verbunden sind und die Substratträger (6) sich zwischen der Anode (5) und den Magnetronsputterquellen (3) oder Arcverdampferquellen befinden.

2. Vakuumbeschichtungsanlage nach Anspruch 1, **dadurch gekennzeichnet, dass** die Magnetronsputterquellen (3) oder Arcverdampferquellen mit DC-Spannungsquellen (15, 15) verbunden sind.

3. Vakuumbeschichtungsanlage nach Anspruch 1, **dadurch gekennzeichnet, dass** die Puls-Spannungsquelle (19) mit einer unsymmetrischen Pulsfolge von positiven und negativen Pulsen die Anode (5) versorgt.

4. Vakuumbeschichtungsanlage nach Anspruch 1, **dadurch gekennzeichnet, dass** in der elektrischen Zuleitung der Pulsspannungsquelle (19) zur Anode (5) eine schaltbare Einrichtung (24) positioniert ist, die nur positive Pulse passieren lässt.

5. Vakuumbeschichtungsanlage nach Anspruch 4, **dadurch gekennzeichnet, dass** die schaltbare Einrichtung (24) zumindest eine Sperrdiode für negative Pulse enthält.

6. Vakuumbeschichtungsanlage nach Anspruch 1, **dadurch gekennzeichnet, dass** die Pulsspannungsquellen (18, 19) Spannungen im Bereich von -500 V bis +500 V erzeugen.

7. Vakuumbeschichtungsanlage nach Anspruch 1, **dadurch gekennzeichnet, dass** die Frequenz der Pulsspannungsquellen (18, 19) im Bereich von 5 bis 300 kHz liegt.

8. Vakuumbeschichtungsanlage nach Anspruch 1, **dadurch gekennzeichnet, dass** das Material der Anode Al, AlCr, ZrN, CrN, TiAlN ist.

9. Vakuumbeschichtungsanlage nach einem der Ansprüche 1 bis 8, **dadurch gekennzeichnet, dass** das Material der Anode (5) das gleiche Material ist, das in den Targets der Kathoden (3) enthalten ist.

10. Vakuumbeschichtungsanlage nach Anspruch 8, **dadurch gekennzeichnet, dass** die Anode mit einem Graphitmantel (5') überzogen ist.

## Claims

1. A vacuum coating installation for homogeneous PVD coating of three-dimensional substrates (4), comprising a coating chamber (2), two or more magnetron sputtering sources (3) or arc evaporator sources arranged peripherally within the coating chamber (2), one or more substrate carriers (6) for holding the substrates (4), vacuum pumps (8) and voltage sources (15, 16, 17, 18, 19), **characterized in that** an individual, central anode (5) is connected to a pulsed voltage source (19) and the respective magnetron sputtering sources or arc evaporator sources are connected to pulsed voltage sources (18, 18, ...) and the substrate carriers (6) are positoned between the anode (5) and magnetron sputtering sources (3) or arc evaporator sources.

2. The vacuum coating installation as claimed in claim 1, **characterized in that** the magnetron sputtering sources (3) or arc evaporator sources are connected to DC voltage sources (15, 15).

3. The vacuum coating installation as claimed in claim 1, **characterized in that** the pulsed voltage source (19) supplies the anode (5) with an asymmetrical pulse sequence of positive and negative pulses.

4. The vacuum coating installation as claimed in claim 1, **characterized in that** a switchable device (24) that permits only positive pulses to pass is positioned in the electrical feed line from the pulsed voltage source (19) to the anode (5).

5. The vacuum coating installation as claimed in claim 1, **characterized in that** the switchable device (24) contains at least one blocking diode for negative pulses.

6. The vacuum coating installation as claimed in claim 1, **characterized in that** the pulsed voltage sources (18, 19) generate voltages in the range of -500 V to +500 V.

7. The vacuum coating installation as claimed in claim 1, **characterized in that** the frequency of the pulsed voltage sources (18, 19) lies in the range of 5 to 300 kHz.

8. The vacuum coating installation as claimed in claim 1, **characterized in that** the material of the anode is Al, AlCr, ZrN, CrN, TiAlN.

9. The vacuum coating installation as claimed in any of claims 1 to 8, **characterized in that** the material of the anode (5) is the same material that is contained in the targets of the cathodes (3).

10. The vacuum coating installation as claimed in claim 8, **characterized in that** the anode is covered with a graphite sheath (5').

## Revendications

1. Installation de revêtement sous vide pour un revêtement PVD homogène de substrats (4) tridimensionnels, comprenant une chambre de revêtement (2), deux ou plusieurs sources de pulvérisation cathodique magnétron (3) ou sources d'évaporateur à arc disposées en périphérie à l'intérieur de la chambre de revêtement (2), un ou plusieurs supports de substrats (6) pour le maintien des substrats (4), des pompes à vide (8) et des sources de tension (15, 16, 17, 18, 19), **caractérisée en ce que** seulement une anode (5) unique centrale avec une source de tension d'impulsion (19), et les sources de pulvérisation cathodique magnétron ou les sources d'évaporateurs à arc respectives sont reliées avec des sources de tension d'impulsion (18, 18, ...) et les supports de substrats (6) se situent entre l'anode (5) et les sources de pulvérisation cathodique magnétron (3) ou les sources d'évaporateur à arc.

2. Installation de revêtement sous vide selon la revendication 1, **caractérisée en ce que** les sources de pulvérisation cathodique magnétron (3) ou les sources d'évaporateur à arc sont reliées avec des sources de tension continue (15, 15).

3. Installation de revêtement sous vide selon la revendication 1, **caractérisée en ce que** la source de tension d'impulsion (19) alimente l'anode (5) avec une suite d'impulsions non symétrique d'impulsions positives et négatives.

4. Installation de revêtement sous vide selon la revendication 1, **caractérisée en ce que**, dans la ligne d'alimentation électrique de la source de tension d'impulsion (19), un équipement commutable (24) est positionné vers l'anode (5) qui ne laisse passer que des impulsions positives.

5. Installation de revêtement sous vide selon la revendication 4, **caractérisée en ce que** l'équipement commutable (24) contient au moins une diode de désactivation pour des impulsions négatives.

6. Installation de revêtement sous vide selon la revendication 1, **caractérisée en ce que** les sources de tension d'impulsion (18, 19) génèrent des tensions dans la gamme de -500 V à +500 V.

7. Installation de revêtement sous vide selon la revendication 1, **caractérisée en ce que** la fréquence des sources de tension d'impulsion (18, 19) se situe dans la gamme de 5 à 300 kHz.

8. Installation de revêtement sous vide selon la revendication 1, **caractérisée en ce que** le matériau de l'anode est Al, AlCr, ZrN, CrN, TiAlN.

9. Installation de revêtement sous vide selon l'une des revendications 1 à 8, **caractérisée en ce que** le matériau de l'anode (5) est le même matériau que celui qui est contenu dans les cibles des cathodes (3).

10. Installation de revêtement sous vide selon la revendication 8, **caractérisée en ce que** l'anode est revêtue d'une enveloppe de graphite (5').
